Europäisches Patentamt

European Patent Office

Office européen des brevets

(11) Veröffentlichungsnummer: **0 093 734**
B1

(12) # EUROPÄISCHE PATENTSCHRIFT

(45) Veröffentlichungstag der Patentschrift:
05.06.85

(21) Anmeldenummer: 82903237.4

(22) Anmeldetag: 10.11.82

(86) Internationale Anmeldenummer:
PCT/EP 82/00241

(87) Internationale Veröffentlichungsnummer:
WO/8301886 (26.05.83 Gazette 83/13)

(51) Int. Cl.⁴: H 05 K 3/42, H 05 K 3/12

(54) VERFAHREN ZUM DURCHKONTAKTIEREN EINER LEITERPLATTE.

(30) Priorität: 17.11.81 DE 3145584

(43) Veröffentlichungstag der Anmeldung:
16.11.83 Patentblatt 83/46

(45) Bekanntmachung des Hinweises auf die Patenterteilung: 05.06.85 Patentblatt 85/23

(84) Benannte Vertragsstaaten:
DE FR GB

(56) Entgegenhaltungen:
WO-A-81 /014 94
DE-B- 1 521 441
FR-A- 1 566 978
GB-A- 989 624
GB-A- 1 094 447
US-A- 3 576 669

(73) Patentinhaber: ROBERT BOSCH GMBH
Postfach 50
D-7000 Stuttgart 1 (DE)

(72) Erfinder: GRÜNWALD, Werner
R.-Schumann-Strasse 21
D-7016 Gerlingen (DE)
Erfinder: SCHMID, Kurt
Schlossstrasse 55
D-7257 Ditzingen 4 (DE)

## Beschreibung

### Stand der Technik

Die Erfindung geht aus von einem Verfahren zum Durchkontaktieren einer Leiterplatte nach der Gattung des Hauptanspruches. Eine derartige durchkontaktierte Leiterplatte ist beispielsweise aus der DE-OS 2 920 091 bekannt, worin ausgeführt ist, daß die aufgerauhte Seitenwand einer Bohrung mit einer Metallisierung versehen ist. Eine derartige Metallisierung wird in bekannter Weise aufgebracht durch Kathodenzerstäubung und anschließend galvanisch verstärkt.

Die DE-B-1 521 441 betrifft ein Verfahren zum Aufdrucken von elektrisch leitenden Schichten auf Durchbruchswandungen mittels einer der zu bedruckenden Wandungskontur entsprechenden Druckform.

Andere bekannte Verfahren zur Herstellung flächenhafter elektrisch leitfähiger Beschichtungen arbeiten mit Aufrollverfahren oder Aufstreichverfahren. Weiterhin sind Siebdruckverfahren bekannt zum Aufbringen elektrisch leitfähiger Schichten.

Aus der DE-OS 3 014 877 ist ferner ein Verfahren zum Auftragen einer Abgas-Sauerstoff-Sensorelektrode (Lambda-Sonde) bekannt, bei der eine elektrisch leitfähige Flüssigkeit dosiert in einen Hohlkörper eingebracht und mittels eines aufblähbaren, fingerartigen Teiles in den Hohlkörper verteilt wird. Schließlich sind elektrisch leitfähige Pasten der interessierenden Art beispielsweise bekannt aus der DE-OS 29 13 633 und aus der DE-OS 30 02 112. Von den bekannten leitfähigen Pasten eignen sich insbesondere Pasten mit einem hohen Edelmetallgehalt, vorzugsweise mit Silber, zum Auftragen der erfindungsgemäßen Durchkontaktierungsschicht. Weiterhin werden von der Fa. Du Pont de Nemours/USA oder Düsseldorf, geeignete leitfähige Pasten im Handel vertrieben, beispielsweise eine AgPd-Paste unter der Kennummer 9473. Diese Paste kann bei Bedarf mit einem unter der Kennummer 9180 von der gleichen Firma angebotenen Verdünner gemischt werden. Eine geeignete Silberpaste wird beispielsweise von der Fa. ESL/Pennsauken-New Jersey/USA unter der Kennummer 111OS vertrieben.

Die FR-A-1 566 978 betrifft einen elastisch verformbaren Druckstempel, welcher sich den Unebenheiten der Oberfläche des Trägers anpaßt.

### Vorteile der Erfindung

Das erfindungsgemäße Verfahren mit den kennzeichnenden Merkmalen des Hauptanspruches gestattet es in besonders vorteilhafter Weise, runde oder andersartig geformte Bohrungen in Leiterplatten bei exakter Dosierung der aufzutragenden Paste gleichmäßig zu beschichten. Das vorgeschlagene Verfahren ist gegenüber herkömmlichen Verfahren äußerst wirtschaftlich, da aufwendige Fertigungstechniken wie beispielsweise Vakuumprozesse entfallen. Durch die exakte Dosierbarkeit der aufzutragenden Paste können erhebliche Kosten eingespart werden durch die Einsparung teurer Edelmetalle.

Durch die in den Unteransprüchen aufgeführten Maßnahmen sind vorteilhafte Weiterbildungen und Verbesserungen des im Hauptanspruch angegebenen Verfahrens möglich. Insbesondere das Aufdrucken der Paste mittels eines spitz zulaufenden Stempels gewährleistet eine vollständige Beschichtung und einen gleichmäßigen Auftrag der Paste in der Bohrung, da sich ein derartiger Druckstempel besonders gut der Innenkontur einer Bohrung anpaßt. Das Abnehmen der Druckpaste von einem ebenen Klischee hat den Vorteil, daß das Einbringen der Druckpaste in die Ausnehmung des Klischees besonders leicht, beispielsweise durch Aufstreichen, erfolgen kann. Die Ätztiefe des Klischees liegt vorteilhafterweise in der Größenordnung von 80 μm. Insbesondere beim Durchkontaktieren von Bohrungen, deren Durchmesser klein im Verhältnis zur Dicke der Leiterplatte ist, hat sich die Verwendung eines Gegenlagers bewährt, um den elastisch verformbaren Druckstempel mit der aufzutragenden Paste über der gesamten Oberfläche der Bohrung sicher an die Bohrungswand anzupressen. Bei Bohrungen geringerer Tiefe kann dieses Gegenlager ohne Nachteil entfallen.

### Zeichnung

Ein Ausführungsbeispiel der Erfindung ist in der Zeichnung schematisch dargestellt und in der nachfolgenden Beschreibung näher erläutert. Es zeigen Figur 1 das Aufnehmen der leitfähigen Paste durch einen elastisch verformbaren Druckstempel von einem Klischee, Figur 2 das Einführen des Druckstempels in die Bohrung einer Leiterplatte und Figur 3 die Verformung des Druckstempels.

### Beschreibung des Ausführungsbeispiels

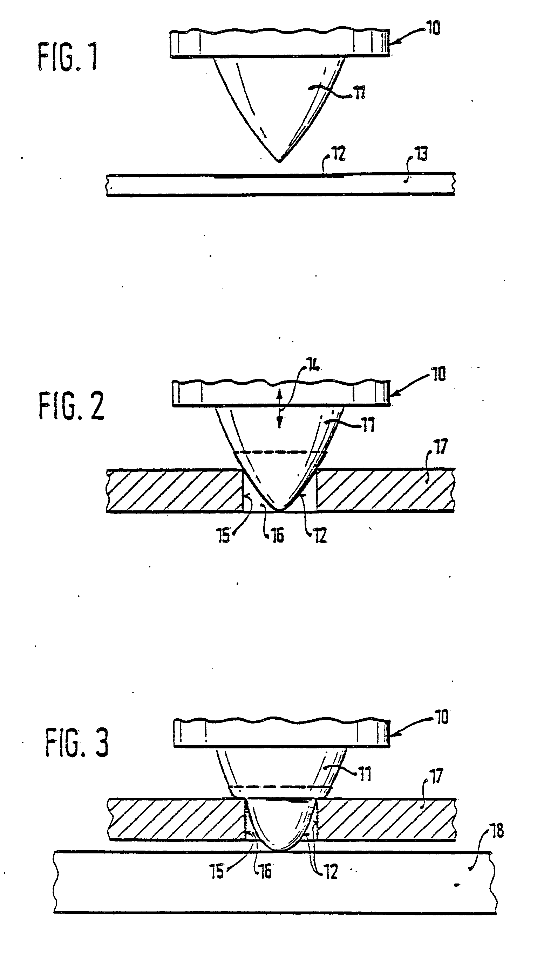

In Figur 1 ist mit 10 ein Druckstempel bezeichnet, dessen Spitze aus einem Silikongummiteil 11 besteht, welches die hinsichtlich Form und Menge vorgegebene Paste 12 von einem Klischee 13 abnimmt.

In den Figuren 2 und 3 sind gleiche Teile mit gleichen Bezugszeichen versehen. Die an dem Silikongummiteil 11 haftende Paste wird durch eine translatorische Bewegung entsprechend dem Pfeil 14 in Figur 2 auf die Wand 15 einer Bohrung 16 in einer Leiterplatte 17 übertragen.

In Figur 3 ist der Druckvorgang kurz vor seinem Abschluß skiziiert, wobei mit strichpunktierten Linien der Auftrag der leitfähigen Paste auf der inneren Wand 15 der Bohrung sowie in der Randzone an der oberen Stirnseite der Bohrung 16 angedeutet ist. Figur 3 zeigt zusätzlich eine Bodenplatte 18, welche als Gegenlager für das Silikongummiteil 11 des Druckstempels 10 dient und das Silikongummiteil 11 im unteren Bereich der Bohrung an die Wand 15 andrückt.

Das erfindungsgemäße Verfahren zum Durchkontaktieren einer Leiterbahn arbeitet nach den dargestellten Schritten im Prinzip folgendermaßen:

Die elektrisch leitfähige Paste 12 wird auf ein ebenes Klischee 13 aufgestrichen und durch Abrakeln auf den in einer Tiefe zwischen 35 μm und 120 μm, vorzugsweise von 80 μm, ausgeätzten Bereich begrenzt. Von dem Klischee 13 wird die Paste 12 durch eine vertikale Bewegung des Druckstempels 10 abgenommen, wobei sich der Silikongummiteil verformt und im Bereich seiner Spitze mit der Paste 12 belegt wird. Für das erfindungsgemäße Verfahren hat sich besonders ein spitz zulaufendes Silikongummiteil 11 bewährt, dessen Zuspitzung noch dem Durchmesser der zu bedruckenden Bohrung angepaßt werden kann. Je dünner die Bohrung desto spitzer sollte das Silikongummiteil 11 zulaufen. Statt eines spitz zulaufenden Silikongummiteils 11 kann jedoch auch beispielsweise ein zylindrisches Silikongummiteil verwendet werden, das durch ein Gegenlager verformt und in seinem Radius derart vergrößert wird, daß es an der Innenwand 15 der Bohrung 16 zur Anlage kommt.

Figur 3 zeigt den eigentlichen Druckvorgang. Nach dem Einführen in die Bohrung 16 kommt das Silikongummiteil 11 am oberen Rand der Bohrung 16 zur Anlage und verformt sich in der gezeichneten Weise, wobei das Anpressen an die innere Wand 15 der Bohrung 16 durch das Unterlegen einer Bodenplatte 18 verstärkt werden kann. Die Bodenplatte 18 kann entweder direkt an der Leiterplatte 17 anliegen oder in geringem Abstand zur Leiterplatte angeordnet werden, um bei kleinem Lochdurchmesser im Verhältnis zur Dicke der Leiterplatte 17 eine einwandfreie Beschichtung des unteren Bereiches der Wand 15 zu gewährleisten. Im Kontakt mit der Wand 15 wird die leitfähige Paste 12 von dem Silikongummiteil 11 auf die Wand 15 übertragen.

Besonders gute Ergebnisse wurden erzielt mit dem erfindungsgemäßen Verfahren bei einem Verhältnis des Bohrungsdurchmessers zur Leiterplattendicke in der Grössenordnung von 1:1, jedoch kann ein einwandfreies Bedrucken auch bei einem Dickenverhältnis von 1:2 zumindest dann gewährleistet werden, wenn das Silikongummiteil 11 durch ein Gegenlager in Form der Bodenplatte 18 von der Austrittsöffnung der Bohrung 16 her verformt wird. Bei Anordnung der Bodenplatte 18 im Abstand zur Leiterplatte 17 kann sogar erreicht werden, daß sich die Paste 12 auch um die Bohrung 16 herum auf die Unterseite der Leiterplatte 17 überträgt.

Mit dem erfindungsgemäßen Verfahren können Bohrungen 16 in beliebigen Leiterplatten 17 mit einer leitfähigen Beschichtung versehen werden. Bei einer Leiterplatte 17 aus hochtemperaturbeständigem Material, beispielsweise aus Keramik oder emailliertem Stahl, eignet sich als Beschichtungspaste 12 insbesondere eine handelsübliche Paste aus einer Mischung von Silber und Paladium, welche bei hohen Temperaturen von ca 850 °C an Luft eingebrannt wird. Zum Bedrucken einer Bohrung 16 in einer Leiterplatte 17 aus weniger temperaturbeständigem Material, z. B. aus Kunststoff, eignet sich insbesondere eine Silberpaste, welche an Luft bei Temperaturen vom ca 200 °C eingebrannt wird. Geeignete Silberpasten sind beispielsweise in der eingangs genannten Literatur beschrieben und als Dickschichtpasten ebenfalls auf dem Markt erhältlich.

## Patentansprüche

1. Verfahren zum Durchkontaktieren einer Leiterplatte, bei dem die Wand einer Bohrung mit einer elektrisch leitfähigen Beschichtung versehen wird, dadurch gekennzeichnet, daß die Beschichtung durch Aufdrucken einer elektrisch leitfähigen Paste (12) mittels eines elastisch derart verformbaren Druckstempels (10, 11) erfolgt, daß sich dieser der Innenkontur der Bohrung anpaßt.

2. Verfahren nach Anspruch 1, dadurch gekennzeichnet, daß das Aufdrucken mittels eines spitz zulaufenden, elastisch verformbaren Teiles (11) eines Druckstempels (10) erfolgt, der zuvor die elektrisch leitfähige Paste (12) von einem ebenen Klischee (13) abnimmt.

3. Verfahren nach Anspruch 2, dadurch gekennzeichnet, daß das Klischee (13) eine Ätztiefe zwischen 35 μm und 120 μm, vorzugsweise von ca 80 μm aufweist.

4. Verfahren nach einem der Ansprüche 1 bis 3, dadurch gekennzeichnet, daß ein Silikongummiteil (11) auf dem Rand der Bohrung (16) zur Auflage gebracht und gleichzeitig von der anderen Seite der Bohrung (16) her durch ein Gegenlager (18) verformt und an die Wand (15) der Bohrung (16) angedrückt wird.

5. Verfahren nach einem der Ansprüche 1 bis 4, dadurch gekennzeichnet, daß eine Leiterplatte (17) aus Keramik oder aus emailliertem Stahl mit einer AgPd-Paste bedruckt wird, welche anschließend bei 800 °C bis 900 °C an Luft eingebrannt wird.

6. Verfahren nach einem der Ansprüche 1 bis 4, dadurch gekennzeichnet, daß eine Leiterplatte (17) aus Kunststoff mit einer Silberpaste bedruckt wird, welche anschließend bei ca 150 °C bis 250 °C an Luft eingebrannt wird.

## Claims

1. Method for plating through a circuit board, in which method the wall of a hole is provided with an electrically conductive coating, characterised in that the coating is carried out by printing on an electrically conductive paste (12) by means of a printing stamp (10, 11) which is elastically deformable in such a manner that it adapts its shape to the inside contour of the hole.

2. Method according to Claim 1, characterised in that the printing-on is carried out by means of a tapered elastically deformable part (11) of a printing stamp (10) which first removes the electrically conductive paste (12) from a plane printing block (13).

3. Method according to Claim 2, characterised in that the printing block (13) has an etching depth of between 35 μm and 120 μm, preferably of about 80 μm.

4. Method according to one of Claims 1 to 3, characterised in that a silicone rubber part (11) is brought to rest against the edge of the hole (16) and is simultaneously deformed by a thrust bearing (18) from the other side of the hole (16) and is pressed against the wall (15) of the hole (16).

5. Method according to one of Claims 1 to 4, characterised in that an AgPd paste is printed on a circuit board (17) of ceramic or of enamelled steel and is subsequently burned in at 800 °C to 900 °C in air.

6. Method according to one of Claims 1 to 4, characterised in that a silver paste is printed on a circuit board (17) of plastic and is subsequently burned in at approximately 150 °C to 250 °C in air.

**Revendications**

1. Procédé pour rendre conductrices les parois d'une plaque conductrice, selon lequel on revêt un perçage de la paroi avec un revêtement conducteur d'électricité, caractérisé en ce que le revêtement se fait en appliquant une pâte conductrice d'électricité (12) à l'aide d'un poinçon de pression (10, 11) déformable élastiquement de façon que celui-ci s'adapte au contour intérieur du perçage.

2. Procédé selon la revendication 1, caractérisé en ce que l'application sous pression se fait à l'aide d'une pièce (11) pointue, déformable élastiquement, d'un poinçon de pression (10) qui prend au préalable la pâte conductrice d'électricité (12) sur un cliché-plan (13).

3. Procédé selon la revendication 2, caractérisé en ce que le cliché (13) a une profondeur de corrosion comprise entre 35 microns et 120 microns de préférence de l'ordre de 80 microns.

4. Procédé selon l'une des revendications 1 à 3, caractérisé en ce qu'une pièce en caoutchouc au silicone (11) est mise en appui sur le bord du perçage (16) et est en même temps déformée à partir de l'autre côté du perçage (16) par un contre-appui (18) et est poussée contre la paroi (15) du perçage (16).

5. Procédé selon l'une des revendications 1 à 4, caractérisé en ce qu'on imprime une plaque conductrice (17) en matière céramique ou en acier émaillé avec une pâte AgPd qui est brûlée à la suite de cela à l'air à une température de 800 °C-900 °C.

6. Procédé selon l'une des revendications 1 à 4, caractérisé en ce qu'on imprime une plaque conductrice (17) en matière synthétique avec une pâte d'argent que l'on brûle à la suite de cela à l'air à une température de 150 °C-250 °C.

FIG. 1

FIG. 2

FIG. 3